(19) Europäisches Patentamt
European Patent Office
Office européen des brevets

(11) Veröffentlichungsnummer: **0 097 333**
**A2**

(12) # EUROPÄISCHE PATENTANMELDUNG

(21) Anmeldenummer: 83105909.2

(22) Anmeldetag: 16.06.83

(51) Int.Cl.[3]: C 08 G 77/20
C 08 G 77/10, C 09 D 3/82
C 08 J 3/28

(30) Priorität: 18.06.82 DE 3222839

(43) Veröffentlichungstag der Anmeldung: 04.01.84 Patentblatt 84/1

(84) Benannte Vertragsstaaten: BE DE GB NL

(71) Anmelder: **WACKER-CHEMIE GMBH**
**Prinzregentenstrasse 22**
**D-8000 München 22(DE)**

(72) Erfinder: **Hockemeyer, Friedrich**
**Mühlbachstrasse 30**
**D-8261 Emmerting(DE)**

(72) Erfinder: **Preiner, Gerhard, Dr.**
**Lärchenstrasse 11**
**D-8261 Marktl(DE)**

(54) **Neue Organopolysiloxane, Verfahren zu ihrer Herstellung und Verwendung dieser Organopolysiloxane.**

(57) Organopolysiloxane, die in ein und demselben Molekül sowohl SiC-gebundene Acryloxyalkylgruppen als auch Si-gebundenen Wasserstoff enthalten, sind dadurch gekennzeichnet, daß sie eine Viskosität von mindestens 100 mPa.s bei 25°C aufweisen. Sie werden vorzugsweise dadurch hergestellt, daß

an in den endständigen Einheiten je ein Si-gebundenes Wasserstoffatom enthaltende Diorganopolysiloxane Allylalkohol angelagert wird,

die alkoholischen Hydroxylgruppen der so erhaltenen Umsetzungsprodukte mit Acrylsäure verestert werden

und die so erhaltenen, in den endständigen Einheiten je eine SiC-gebundene Acryloxypropylgruppe aufweisenden Diorganopolysiloxan mit in den endständigen Einheiten je eine Si-gebundene Hydroxylgruppe aufweisenden Organo-(poly)-siloxanen aus Methylhydrogensiloxaneinheiten und gegebenenfalls Diorganosiloxaneinheiten der Formel

$$R_2SiO$$

sowie gegebenenfalls anderen Organo(poly)siloxanen äquilibriert werden.

Die erfindungsgemäßen Organopolysiloxane eignen sich ausgezeichnet zur Herstellung von durch energiereiche Strahlung, insbesondere Ultraviolett-Licht, vernetzbaren Überzügen z.B. auf Papier zur Abweisung von klebrigen Stoffen oder auf Lichtleit-Glasfasern.

EP 0 097 333 A2

0097333

WACKER-CHEMIE GMBH

München, den 08.06.1982
LC-PAT/Dr.Ru/hu
Wa 8212-S

Neue Organopolysiloxane, Verfahren zu ihrer Herstellung und Verwendung dieser Organopolysiloxane.

---

Aus EP-OS 00 16 663, ausgegeben 1. Oktober 1980, Rhone-Poulenc Industries, sind bereits photopolymerisierbare Organopolysiloxanzusammensetzungen mit SiC-gebundenen Acryloxyalkyl- oder Methacryloxyalkylgruppen, die zur Herstellung von klebrige Stoffe abweisenden Überzügen verwendet werden können, bekannt. Organopolysiloxane der Erfindung vernetzen in Gegenwart von Luft-Sauerstoff rascher.

Gegenstand der Erfindung sind Organopolysiloxane, die in ein und demselben Molekül sowohl SiC-gebundene Acryloxyalkylgruppen als auch Si-gebundenen Wasserstoff enthalten, dadurch gekennzeichnet, daß sie eine Viskosität von mindestens 100 mPa.s bei 25°C aufweisen.

Aus US 4 011 247, ausgegeben 8. März 1977, Yasuhiko Sato et al., Shinetsu Chemical Company, sind bereits Organopolysiloxane, die in ein und demselben Molekül sowohl SiC-gebundene Acryloxyalkylgruppen als auch Si-gebundenen Wasserstoff enthalten, bereits bekannt. Diese bereits bekannten Organopolysiloxane besitzen jedoch Viskositäten von weniger als 100 mPa.s bei 25°C, damit sie durch Destillation gereinigt werden können. Eine Eignung dieser bekannten Organopolysiloxane zur Herstellung von klebrige Stoffe abweisenden Überzügen ist weder in US 4 011 247 offenbart noch anzunehmen.

Vorzugsweise haben die erfindungsgemäßen Organopolysiloxane eine Viskosität von mindestens 300 mPa.s und höchstens $10.10^6$ mPa.s bei 25°C und durchschnittlich höchstens 3000 mPa.s bei 25°C .

Weiterhin sind als erfindungsgemäße Organopolysiloxane solche bevorzugt, die aus Siloxaneinheiten der Formel

$$CH_2=CHCOO(CH_2)_nSiR_2O_{1/2},$$

wobei R gleiche oder verschiedene, einwertige, gegebenenfalls substituierte Kohlenwasserstoffreste und n 1, 2, 3 oder 4, insbesondere 3, bedeutet,

$$R_2SiO,$$

wobei R die vorstehend dafür angegebene Bedeutung hat, und

$$CH_3HSiO$$

aufgebaut sind.

Vorzugsweise enthalten die erfindungsgemäßen Organopolysiloxane mindestens 2 und höchstens 4 Einheiten der Formel

$$CH_2=CHCOO(CH_2)_nSiR_2O_{1/2}.$$

Vorzugsweise beträgt der Anteil der Einheiten der Formel

$$R_2SiO$$

an der Gesamtzahl der Siloxaneinheiten in den bevorzugten erfindungsgemäßen Organopolysiloxanen mindestens 10 % und höchstens 95 %.

Vorzugsweise beträgt der Anteil der Einheiten der Formel

$$CH_3HSiO$$

an der Gesamtzahl der Siloxaneinheiten in den bevorzugten erfindungsgemäßen Organopolysiloxanen 0,2 bis 75 %, insbesondere 5 bis 20 %.

Zusätzlich zu den oben genannten Siloxaneinheiten können die bevorzugten erfindungsgemäßen Organopolysiloxane gegebenenfalls auch z. B. Einheiten der Formel

$$RSiO_{3/2}$$

oder

$$R^1R_2SiO_{1/2},$$

wobei R jeweils die oben dafür angegebene Bedeutung hat und $R^1$ Wasserstoff ist oder die gleiche Bedeutung wie R hat, enthalten. Vorzugsweise beträgt jedoch der Anteil an solchen anderen Einheiten insgesamt höchstens 10 % der Gesamtzahl der Siloxaneinheiten in den erfindungsgemäßen Organopolysiloxanen.

Die Gesamtzahl der Siloxaneinheiten der erfindungsgemäßen Organopolysiloxane muß natürlich jeweils 100 % betragen.

Wenn auch nicht bevorzugt, können die Einheiten der Formel

$CH_2=CHCOO(CH_2)_nR_2O_{1/2}$

auch teilweise oder vollständig durch Einheiten der Formel

$CH_2=CHCOO(CH_2)_nSiRO$

oder |

$CH_2=CHCOO(CH_2)_nSiO_{3/2}$,

wobei R und n jeweils die dafür angegebene Bedeutung haben, oder ein Gemisch solcher Einheiten ersetzt sein.

Beispiele für Kohlenwasserstoffreste R und $R^1$ in den oben angegebenen Formeln sind Alkylreste mit 1 bis 18 Kohlenstoffatomen je Rest, wie der Methyl-, Ethyl, n-Propyl-, Isopropyl-, n-Butyl- und sec.-Butylrest sowie Octadecylreste; Cycloalkylreste mit 5 bis 8 Kohlenstoffatomen je Rest, wie derCyclohexyl- und Cycloheptylrest sowie Methylcyclohexylreste; Reste mit aliphatischen Doppelbindungen, wie der Vinyl- und Allylrest, wobei solche Reste mit aliphatischen Doppelbindungen insbesondere als Reste $R^1$ vorliegen können; Arylreste, wie der Phenylrest und Xenylreste; Alkarylreste, wie Tolylreste; und Aralkylreste, wie der Benzyl- und der beta-Phenylethylrest.

Beispiele für substituierte Kohlenwasserstoffreste R und $R^1$ in den oben angegebenen Formeln sind insbesondere halogenierte Kohlenwasserstoffreste, wie der 3-Chlorpropyl- und 3,3,3-Trifluorpropylrest und o-, p- und m-Chlorphenylreste.

Insbesondere wegen der leichteren Zugänglichkeit sind jedoch vorzugsweise insgesamt mindestens 95 % der Anzahl der Reste R und $R^1$ Methylreste.

Gegenstand der Erfindung ist weiterhin ein Verfahren zur Herstellung von Organopolysiloxanen, die in ein und demselben Molekül sowohl SiC-gebundene Acryloxyalkylgruppen als auch Si-gebundenen Wasserstoff enthalten und eine Viskosität von mindestens 100 mPa.s bei 25°C aufweisen,
dadurch gekennzeichnet, daß
an in den endständigen Einheiten je ein Si-gebundenes Wasserstoffatom enthaltende Diorganopolysiloxane Allylalkohol angelagert wird,
die alkoholischen Hydroxylgruppen der so erhaltenen Umsetzungsprodukte mit Acrylsäure verestert werden
und die so erhaltenen, in den endständigen Einheiten je eine SiC-gebundene Acryloxypropylgruppe aufweisenden Diorganopolysiloxane mit in den endständigen Einheiten je eine Si-gebundene Hydroxylgruppe aufweisenden Organo(poly)siloxanen aus Methylhydrogensiloxaneinheiten und gegebenenfalls Siloxaneinheiten der Formel

$$R_2SiO,$$

wobei R die oben dafür angegebene Bedeutung hat, sowie gegebenenfalls anderen Organo(poly)siloxanen äquilibriert werden, wobei der Anteil an monofunktionellen Siloxaneinheiten so zu wählen ist, daß das durch Äquilibrieren erhaltene Organopolysiloxan eine Viskosität von mindestens 100 mPa.s bei 25°C besitzt.

Die in den endständigen Einheiten je ein Si-gebundenes Wasserstoffatom enthaltenden Diorganopolysiloxane, die bei der 1. Stufe des erfindungsgemäßen Verfahrens eingesetzt werden, können durch die allgemeine Formel

$$HSiR_2O(SiR_2O)_mSiHR_2$$

wiedergegeben werden, wobei R die oben dafür angegebene Bedeutung hat und m eine ganze Zahl im Wert von mindestens 1 ist. Die Anlagerung von Allylalkohol an die beiden Si-gebundenen Wasserstoffatome kann durch beliebige, die Anlagerung von Si-gebundenem Wasserstoff an aliphatische Mehrfachbindung fördernde Katalysatoren, wie Platinkatalysatoren, z. B. $H_2PtCl_6 \cdot 6H_2O$, gefördert werden. Die Anlagerung von Allylalkohol an in den endständigen Einheiten je ein Si-gebundenes Wasserstoffatom enthaltendes Diorganopolysiloxan kann bei beliebigen Temperaturen und Drücken erfolgen, bei denen auch bisher die Anlagerung von Si-gebundenem Wasserstoff an aliphatische Mehrfachbindung durchgeführt wurde. Bevorzugt sind 20 bis 150°C und der Druck der umgebenden Atmosphäre. Vorzugsweise wird Allylalkohol in Mengen von mindestens 1 Grammol je Grammatom Si-gebundenen Wasserstoffs eingesetzt. Die in der 1. Stufe des erfindungsgemäßen Verfahrens erhaltenen Umsetzungsprodukte haben die Formel

$$HO(CH_2)_3SiR_2O(SiR_2)_mSiR_2(CH_2)_3OH,$$

wobei R und m jeweils die oben dafür angegebene Bedeutung haben.

Die Veresterung der alkoholischen Hydroxylgruppen der in der 1. Stufe des erfindungsgemäßen Verfahrens erhaltenen Umsetzungsprodukte mit Acrylsäure kann vorteilhafterweise mit einem leichtzugänglichen Festbettkatalysator, wie säurebehandeltem Montmorillonit, der durch einfaches Filtrieren aus dem Reaktionsprodukt entfernt werden kann, erfolgen. Die Veresterung der alkoholischen Hydroxylgruppen der in der 1. Stufe des erfindungsgemäßen Verfahrens erhaltenen Umsetzungsprodukte mit Acrylsäure kann bei beliebigen Temperaturen und Drücken erfolgen, bei denen auch bisher Veresterungen von alkoholischen Hydroxylgruppen mit Carbonsäuren durchgeführt wurden. Bevorzugt sind 50 bis 180°C und der Druck der umgebenden Atmosphäre. Vorzugsweise wird Acrylsäure in Mengen von mindestens 1 Grammol je Grammol alkoholischer Hydroxylgruppe eingesetzt. Die bei der 2. Stufe des erfindungsgemäßen Verfahrens erhaltenen, in den endständigen Einheiten je eine SiC-gebundene Acryloxypropylgruppe aufweisenden Diorganopolysiloxane haben die Formel

$$CH_2{=}CHCOO(CH_2)_3SiR_2O(SiR_2O)_mSiR_2(CH_2)_3OOCHC{=}CH_2,$$

wobei R und m jeweils die oben dafür angegebene Bedeutung haben.

Die in den endständigen Einheiten je eine Si-gebundene

Hydroxylgruppe aufweisenden Organo(poly)siloxane aus Methylhydrogensiloxaneinheiten und gegebenenfalls Siloxaneinheiten der Formel

$R_2SiO$,

wobei R die oben dafür angegebene Bedeutung hat, mit denen sowie gegebenenfalls anderen Organo(poly)siloxanen in der 3. Stufe des erfindungsgemäßen Verfahrens die in den endständigen Einheiten je eine SiC-gebundene Acryloxypropylgruppe aufweisenden Diorganopolysiloxane äquilibriert werden, können durch die allgemeine Formel

$H(OSiCH_3H)_e(OSiR_2)_pOH$

wiedergegeben werden. In dieser Formel hat R die oben dafür angegebene Bedeutung, e ist eine ganze Zahl im Wert von mindestens 1 und p ist O oder eine ganze Zahl im Wert von mindestens 1.

Bei den anderen Organopolysiloxanen, die in der 3. Stufe des erfindungsgemäßen Verfahrens ggf. mitverwendet werden können, kann es sich beispielsweise um in den endständigen Einheiten je eine Si-gebundene Hydroxylgruppe aufweisende Diorganopolysiloxane, insbesondere um in den endständigen Einheiten je eine Si-gebundene Hydroxylgruppe aufweisende Dimethylpolysiloxane, cyclische Diorganopolysiloxane, wie Octamethylcyclotetrasiloxan , oder Mischpolymerisate aus Einheiten der Formel

$R_2SiO$ und $RSiO_{3/2}$,

wobei R jeweils die oben dafür angegebene Bedeutung hat, handeln.

Bei dem Äquilibrieren in der 3. Stufe des erfindungsgemäßen Verfahrens werden vorzugsweise saure Katalysatoren, welche die Äquilibrierung fördern, eingesetzt. Beispiele für solche Katalysatoren sind Schwefelsäure, Phosphorsäure, Trifluormethansäure, Phosphornitridchloride und unter den Reaktionsbedingungen feste, saure Katalysatoren, wie säureaktivierte Bleicherde, saure Zeolithe, sulfonierte Kohle und sulfoniertes Styrol-Divinylbenzol-Mischpolymerisat. Bevorzugt sind Phosphornitridchloride. Phosphornitridchloride werden vorzugsweise in Mengen von 5 bis 1000 Gewichts-ppm (=Teilen je Million), insbesondere 50 bis 200 Gewichts-ppm, jeweils bezogen auf das Gesamtgewicht der eingesetzten Organosiliciumverbindungen, verwendet.

Die 1. und 2. Stufe des erfindungsgemäßen Verfahrens werden vorzugs- und vorteilhafterweise (zur Erzielung hoher Raum-Zeitausbeuten) jeweils ohne Mitverwendung von Lösungsmittel durchgeführt. Das Äquilibrieren in der 3. Stufe des erfindungsgemäßen Verfahrens wird vorzugsweise in mindestens 10 Gewichtsprozent mit Wasser nicht-mischbarem Lösungsmittel, wie Toluol, bezogen auf das Gesamtgewicht von Organosiliciumverbindungen und Lösungsmittel, durchgeführt, um eine Vernetzung vom Organopolysiloxan durch die unerwünschte Kondensation von Si-gebundenem Wasserstoff mit Si-gebundenen Hydroxylgruppen zu verhindern.

Monofunktionelle Siloxaneinheiten, deren Anteil die Viskosität der bei dem Äquilibrieren erhaltenen Organopolysiloxane regelt, sind insbesondere die Einheiten der Formel

$$CH_2{=}CHCOO(CH_2)_3SiR_2O_{1/2}.$$

Mit steigendem Anteil dieser Siloxaneinheiten sinkt die Viskosität der bei dem Äquilibrieren erhaltenen Organopolysiloxane.

Vor dem Aufarbeiten der bei dem Äquilibrieren erhaltenen Gemische kann der Katalysator unwirksam gemacht werden, z. B. durch Zugabe von Trioctylamin.

Gegenstand der Erfindung ist schließlich auch die Verwendung der Organopolysiloxane, die in ein und demselben Molekül sowohl SiC-gebundene Acryloxyalkylgruppen als auch Si-gebundenen Wasserstoff enthalten und eine Viskosität von mindestens 100 mPa.s bei 25°C besitzen, zur Herstellung von durch energiereiche Strahlung vernetzbaren Überzügen.

Die Überzüge, die aus den erfindungsgemäßen oder erfindungsgemäße herstellbaren Organopolysiloxanen hergestellt werden, sind abweisend gegenüber klebrigen Stoffen und Wasser und eignen sich auch als Schutzüberzüge.

Die Oberflächen, auf/die welche erfindungsgemäßen oder erfindungsgemäß herstellbaren Organopolysiloxane zwecks Herstellung von Überzügen aufgebracht werden können, können sein z. B. diejenigen von keramischen Gegenständen oder Glas, Glasfasern, einschließlich Lichtleitfasern, Papieren, wie Kraftpapier oder Pergaminpapier, Pappen, einschließlich solcher aus Asbest, Zellglas, Holz, Kork, Kunststoffolien, z. B. Polyethylenfolien oder Polypropylenfolien, gewebtem oder ungewebtem Tuch aus natürlichen Fasern oder synthetischen Fasern oder Glasfasern,

Metallen, mit Polyethylen beschichtetem Kraftpapier oder Pappe. Soweit vorstehend Polyethylen genannt wurde, kann es sich dabei jeweils um Hoch-, Mittel- oder Niederdruck-Polyethylen handeln.

Das Auftragen der erfindungsgemäßen oder erfindungsgemäß herstellbaren Organopolysiloxane auf die zu überziehenden Oberflächen kann in beliebiger, für die Herstellung von Überzügen aus flüssigen Stoffen geeigneter und vielfach bekannter Weise erfolgen, beispielsweise durch Tauchen, Streichen, Gießen, Sprühen, Aufwalzen, Drucken, z. B. mittels einer Offsetgravur-Überzugsvorrichtung, Messer- oder Rakelbeschichtung, einschließlich derjenigen mit einem Meyer-Stab (englisch: Meyer-rod), oder mittels einer Luftbürste. Erfolgt das Auftragen mittels einer Offsetgravur-Überzugsvorrichtung, so kann das Substrat mit der zu überziehenden Oberfläche mit höherer Geschwindigkeit laufen als der Formzylinder.

Bei dem Auftragen der erfindungsgemäßen oder erfindungsgemäß herstellbaren Organopolysiloxane auf die zu überziehenden Oberflächen können die Organopolysiloxane gegebenenfalls in Lösungsmittel vorliegen. Vorzugsweise sind jedoch keine Lösungsmittel vorhanden.

Bei der zur Vernetzung der Überzüge angewendeten energiereichen Strahlung handelt es sich vorzugsweise um Ultraviolett-Licht. Es kann sich dabei aber auch z. B. um Röntgen-, gamma- oder Elektronenstrahlen oder um gleichzeitige Anwendung von mindestens zwei verschiedenen Arten solcher Strahlen handeln. Zusätzlich zu der energiereichen Strahlung kann Wärmezufuhr, einschließlich Wärmezufuhr mittels Infrarotlicht, angewendet werden. Eine solche Wärmezufuhr ist jedoch keineswegs erforderlich und vorzugsweise unterbleibt sie, um den Aufwand für Energie zu verringern.

Als Ultraviolettlicht ist solches mit Wellenlängen im Bereich von 200 bis 400 nm (Nanometer) bevorzugt.

Wenn es sich bei der zur Vernetzung der Überzüge angewendeten energiereichen Strahlung um Ultraviolett-Licht handelt,so müssen die erfindungsgemäßen oder erfindungsgemäß herstellbaren Organopolysiloxane im Gemisch mit mindestens einem Photosensibilisator vorliegen. Beispiele für Photosensibilisatoren sindAcetophenon, 2-Ethoxy-2-methylacetophenon, Trichlorbutylacetophenon, 2-Ethoxy-2-phenylacetophenon, Mesityloxyd, Propriophenon, Benzophenon, Xanthon, Thioxanthon, Fluorenon, Benzaldehyd, Fluoren, Anthrachinon, Carbazol, 3-Methylacetophenon, 4-Methylacetophenon, 3-Bromacetophenon, 4-Allylacetophenon, p-Diacetylbenzol, 3-Methoxybenzophenon, 4-Methylbenzophenon, 4-Chlorbenzophenon, 2,4-Bis(trimethylsiloxy)-benzophenon, 4,4'-Dimethoxybenzophenon, 4-Chlor-4'-benzylbenzophenon, 3-Chlorxanthon, 3,9-Dichlorxanthon, 3-Chlor-8-nonylxanthon, Chloranthrachinon, Michlers Keton, Zimtsäure, Benzoinmethylether, Anthrachinon-1,5-disulfonsäuredinatriumsalz, 2-Naphthalinsulfonylchlorid und Benzil sowie Benzilketale und Hydroxybenzophenone. Bevorzugt sind Photosensibilisatoren, die in Organopolysiloxanen löslich sind, wie Bis-(trimethylsiloxy)-benzophenon.

Die Photosensibilisatoren werden vorzugsweise in Mengen von 0,5 bis 5 Gew.-%, bezogen auf das Gewicht der erfindungsgemäßen Organopolysiloxane, eingesetzt.

In den folgenden Beispielen beziehen sich alle Angaben von Teilen und Prozentsätzen auf das Gewicht,soweit nichts anderes angegeben ist.

Beispiel 1

A) Zu 116 g (2 Mol) Allylalkohol und 4,6 ml 1 % Platin in Form von $H_2PtCl_6 \cdot 6H_2O$ enthaltendem Isopropanol, die in einem 2 l-Dreihalskolben auf 80°C erwärmt sind, werden 800 g (1 Mol) in den endständigen Einheiten je ein Si-gebundenes Wasserstoffatom enthaltendes Diorganopolysiloxan der Formel

$$HSi(CH_3)_2O[Si(CH_3]_2O)_9Si(CH_3)_2H$$

tropfenweise gegeben. Anschließend wird eine Stunde bei 100°C gerührt. Nachdem sich das so erhaltene Organopolysiloxan, das gemäß NMR-Spektrum die Formel

$$HO(CH_2)_3Si(CH_3)_2O\ [Si(CH_3O_2]_9Si(CH_3)_2(CH_2)_3OH$$

hat, auf 50°C abgekühlt hat, wird es mit 100 g säurebehandeltem Montmorillonit, 432 g (6 Mol) Acrylsäure und 0,65 Bis-(tert.-butyl)-kresol (als Mittel zur Verhinderung der Polymerisation der Acrylsäure) vermischt und die so erhaltene Mischung 2 Stunden auf 110°C erwärmt. Anschließend wird vom Montmorillonit abfiltriert. Nachdem aus dem Filtrat die bis zu 80°C bei 130 Pa siedenden Stoffe abdestilliert wurden, werden 860 g (90,6 % der Theorie) eines schwach gelblichen, klaren, niederviskosen Öls erhalten, das gemäß NMR-Spektrum die Formel

$$H_2{=}CHCOO(CH_2)_3Si(CH_3)_2O[Si(CH_3)_2O]_9Si(CH_3)_2(CH_2)_3OOCHC{=}CH_2$$

hat.

B) Zu 966g einer 45 %igen Lösung eines den endständigen Einheiten je eine Si-gebundene Hydroxylgruppe aufweisenden Methylhydrogenpolysiloxans mit etwa 20 Si-Atomen je Molekül in Toluol werden 532 g eines in den endständigen Einheiten je eine Si-gebundene Hydroxylgruppe aufweisenden Dimethylpolysiloxans mit etwa 100 Siliciumatomen je Molekül, 80 g des gemäß A) hergestellten in den endständigen Einheiten je eine SiC-gebundene Acryloxypropylgruppe aufweisenden Dimethylpolysiloxans und 1,1 ml einer 25 %-igen Lösung von Phosphornitrilchloriden in Methylenchlorid gegeben. Die so erhaltene Mischung wird 2 Stunden zum Sieden unter Rückfluß erwärmt, wobei Wasser und 300 ml Toluol abdestilliert werden. Danach wird der Gefäßinhalt mit 1,1 ml Trioctylamin zum Unwirksammachen der Phosphornitridchloride vermischt, über Aktivkohle filtriert und von Lösungsmitteln und anderen flüchtigen Stoffen bei 80°C und $1,3 \cdot 10^{2}$ Pa (abs.) in einem Rotationsverdampfer befreit. Es werden 973 g (93 % der Theorie) eines Organopolysiloxans aus Einheiten der Formel

$CH_2=CHCOO(CH_2)_3Si(CH_3)_2O_{1/2}$,

$(CH_3)_2SiO$ , und

$CH_3HSiO$

mit einer Viskosität von 420 mPa.s bei 25°C und 0,66 % Si-gebundenem Wasserstoff, was einem Gehalt der Einheiten der Formel

$CH_3HSiO$

an der Gesamtzahl der Siloxaneinheiten von 45,2 % entspricht, erhalten. Der Anteil der Einheiten der Formel

$(CH_3)_2SiO$

an der Gesamtzahl der Siloxaneinheiten beträgt 53,8 %.

Beispiel 2

100 Teile des Organopolysiloxans, das in ein und demselben Molekül sowohl Acryloxyalkylgruppen als auch Si-gebundenen Wasserstoff enthält und dessen Herstellung in Beispiel 1 beschrieben wurde, werden mit 0,1 Teilen Xanthon vermischt. Die so erhaltene Mischung wird mittels einer Rakel auf ein mit Polyvinylalkohol geleimtes Papier in einer Menge von 5,2 $g/m^2$ aufgetragen. Dabei wird als Rakel ein mit 0,2 mm dickem Draht aus rostfreiem Stahl umwickelter Stab aus rostfreiem Stahl verwendet.

Ein 2 cm breiter und 49 cm langer Streifen des so überzogenen Papiers wird mit der beschichteten Seite nach außen um eine Walze gelegt. Eine Quecksilberhochdruck-Ultraviolett-Lampe mit einer Leistung von 100 Watt/cm Leuchtlänge und einem Maximum der Leistung bei 253,7 nm wird in einem Abstand von 2 cm über der Walze angebracht. Die Walze wird mit einem Elektromotor angetrieben und hat 32 Umdrehungen /Minute. Aus der Umdrehungszahl der Walze und dem Durchmesser der Ultraviolett-Lampe ergibt sich, daß bei einer Umlaufzeit von 1 Minute die Bestrahlungszeit 2,4 Sekunden beträgt. Die Temperatur zwischen Lampe und Papier wird

durch ein Frischluftgebläse bei 60°C gehalten.

Nach dem Entfernen des Papiers von der Walze wird auf die beschichtete Seite des Papiers selbstklebendes (englisch: pressure sensitive) 2 cm breites Klebeband ("Tesafilm rot Nr. 154", Beiersdorf AG, Hamburg, BRD - der Wortteil "Tesa" ist ein registriertes Warenzeichen) gelegt und mittels einer Gummiwalze mit einer Kraft von 20 N aufgedrückt. Nach 20 Stunden Erwärmen auf 70°C unter einer Belastung von 0,2 $N/cm^2$ wird das Klebeband bei 20°C unter einem Winkel von 180° mit einer Geschwindigkeit von 15 cm/Minute von dem Papier abgezogen. Es wird die Kraft, die für dieses Abziehen erforderlich und im folgenden als "Trennwert" bezeichnet ist, gemessen.

I) Die von dem mit Organopolysiloxan beschichteten Papier abgezogenen Klebeband-Streifen werden mittels der Gummiwalze mit der gleichen Kraft, mit der sie vorher auf das beschichtete Papier aufgedrückt wurden, auf unbehandelte Acetatfolie aufgedrückt und dann unter einem Winkel von 180° mit einer Geschwindigkeit von 7,5 cm von der Folie abgezogen.

II) Ein Klebeband der oben näher bezeichneten Art wird mittels der Gummiwalze mit der gleichen Kraft, mit der sie auf das beschichtete Papier aufgedrückt wird, auf unbehandelte Acetatfolie aufgedrückt. Nach 20 Stunden Erwärmen auf 70°C unter der gleichen Belastung, wie sie beim Erwärmen des Klebebands auf dem beschichteten Papier angewendet wird, wird das Klebeband unter einem Winkel von 180° mit einer

Geschwindigkeit von 7,5 cm bei 20°C von der Folie abgezogen. Die dafür erforderliche Kraft wird als "Blindwert" bezeichnet.

Der im folgenden als "Restklebekraft" bezeichnete und in % angegebene Wert ergibt sich aus

$$\frac{\text{Kraft, gemessen nach I)}}{\text{Blindwert, gemessen nach II}} \cdot 100$$

Es werden folgende Ergebnisse erhalten:

| Bestrahlungszeit Sekunden | Trennwert mN/mm | Restklebekraft % |
|---|---|---|
| 7,2 | 5,4 | 66 |
| 12,0 | 6,8 | 79 |
| 16,8 | 7,9 | 82 |

Beim Reiben mit dem Finger auf der Beschichtung konnte nach keiner der vorstehend angegebenen Bestrahlungszeiten ein Abrieb festgestellt werden.

## Beispiel 3

Die in Beispiel 2 angegebene Arbeitsweise wird wiederholt mit der Abänderung, daß 1 Teil Benzoïnmethylether anstelle von 0,1 Teilen Xanthon verwendet wird. Es werden folgende Ergebnisse erhalten:

| Bestrahlungszeit Sekunden | Trennwert mN/mm | Restklebekraft % |
|---|---|---|
| 12 | 6,8 | 57 |
| 16,8 | 6,9 | 67 |

Vergleichsversuche a) bis c)

a) Die in Beispiel 2 angegebene Arbeitsweise wird wiederholt mit den Abänderungen, daß ein Organopolysiloxan der Formel

$$H_2=CHCOO(CH_2)_3Si(CH_3)_2O[Si(CH_3)_2O]_{190}Si(CH_3)_2(CH_2)_3OOCC=CH_2$$

mit einer Viskosität von 416 mPa.s bei 25°C beträgt, anstelle des in ein und demselben Molekül sowohl Acryloxyalkylgruppen als auch Si-gebundenen Wasserstoff enthaltenden Organopolysiloxans und 0,2 Teile Xanthon anstelle von 0,1 Teil Xanthon je 100 Teile Organopolysiloxan eingesetzt werden.

b) Die vorstehend angegebene Arbeitsweise wird wiederholt mit der Abänderung, daß 1 Teil 2,4-Bis-(trimethylsiloxy)-benzophenon anstelle der 0,2 Teile Xanthon eingesetzt werden.

c) Die oben unter a) angegebene Arbeitsweise wird wiederholt mit der Abänderung, daß 1 Teil Benzoïnmethylether anstelle der 0,2 Teile Xanthon eingesetzt werden.

Die Bestrahlungszeiten betragen jeweils 48 Sekunden. Danach ist immer noch keine Vernetzung der Überzüge zu beobachten.

Beispiel 4

100 Teile des Organopolysiloxans, das in ein und demselben Molekül sowohl Acryloxyalkylgruppen als auch Si-gebundenen Wasserstoff enthält und dessen Herstellung in Beispiel 1 beschrieben wurde, werden mit 0,18 Teilen Xanthon vermischt. Die so erhaltene Mischung wird in einer kontinuierlich betriebenen Anlage mittels eines Mehrwalzensystems auf ein auf einem Kalander unter Wasserdampf geglättetes Kraftpapier (Papier aus Sulfatzellstoff) in einer Breite von 0,8 m und in einer Menge von 0,56 bis 0,67 $g/m^2$ aufgetragen, was einer Schichtdicke von 0,56 bis 0,67 Mikrometer entspricht. Der Überzug wird mittels vier Quecksilberhochdruck-Ultraviolett-Lampen, die auf einer Strecke von 80 cm längs der Papierbahn unmittelbar hintereinander in einem Abstand von 2 cm von der Papierbahn angebracht sind, vernetzt. Die Leistung der Ultraviolett-Lampen beträgt 4,5 Kilowatt mit einem Maximum der Leistung bei 253,7 nm, die dabei erzielbare höchste Bahngeschwindigkeit 20 m/Minute. Somit erlaubt die Steigerung der Leistung der Lampen um 1 Kilowatt eine Steigerung der Bahngeschwindigkeit um 4,45 m/Minute.

Bei der Prüfung der Eigenschaften des Überzugs wird "Tesafilm Nr. 969" anstelle von "Tesafilm rot Nr. 154" verwendet.

Trennwert: 16,5 mN/mm
Restklebekraft: 86 %

Beispiel 5

Analog Beispiel 1 hergestelltes Organopolysiloxan aus Einheiten der Formel

$CH_2=CHCOO(CH_2)_3Si(CH_3)O_{1/2}$ ,
$(CH_3)_2SiO$ ,

wobei der Anteil dieser Diorganosiloxaneinheiten an der Gesamtzahl der Siloxaneinheiten etwa 35,9 % beträgt, und Einheiten der Formel

$CH_3HSiO$ ,

wobei der Anteil der Methylhydrogensiloxaneinheiten an der Gesamtzahl der Siloxaneinheiten etwa 63,4 % beträgt, mit einer Viskosität von 360 mPa.s bei 25°C, das mit 0,2 %, bezogen auf sein Gewicht, Xanthon vermischt ist, wird mittels der in Beispiel 2 beschriebenen Rakel in einer Menge von 5,5 $m^2$ auf mit Polyvinylalkohol gestrichenes Kraftpapier aufgetragen und wie in Beispiel 2 beschrieben vernetzt sowie geprüft.

| Bestrahlungszeit Sekunden | Trennwert mN/mm | Restklebekraft % |
|---|---|---|
| 7,2 | 7,3 | 63 |
| 12,0 | 9,7 | 77 |
| 16,8 | 9,8 | 72 |
| 24,0 | 10,5 | 81 |
| 36,0 | 13,0 | 84 |

Bei Reiben mit dem Finger auf der Beschichtung konnte nur nach der Bestrahlungszeit von 7,2 Sekunden ein mäßiger Abrieb festgestellt werden. Bei allen übrigen Bestrahlungszeiten konnte kein Abrieb festgestellt werden.

Beispiele 6 bis 9

Analog Beispiel 1 hergestellte Organopolysiloxane aus Einheiten der Formel

$$CH_2{=}CHCOO(CH_2)_3Si(CH_3)_2O_{1/2}$$

und den anderen in der folgenden Tabelle angegebenen Einheiten werden mit den in der folgenden Tabelle angegebenen Photosensibilisatoren vermischt, mittels der in Beispiel 2 beschriebenen Rakel auf mit Polyvinylalkohol geleimtes Papier in einer Menge von 5,2 $g/m^2$ aufgetragen und mit der in Beispiel 2 beschriebenen Vorrichtung mit einer Bestrahlungszeit von 12,0 Sekunden vernetzt.

Tabelle

| Beispiel | Verhältnis von $CH_3HSiO$ | zu $(CH_3)_2SiO$ | Anteil an der Gesamtzahl der Siloxaneinheiten abzügl. d. endständigen Einheiten $CH_3HSi$ % | $(CH_3)_2SiO$ % | Viskosität des Organopolysiloxans mPa.s bei 25°C | Photosensibilisator Art | Menge % | Restklebekraft % |
|---|---|---|---|---|---|---|---|---|
| 6 | 1 : | 1,3 | 43 | 57 | 400 | 2;4-Bis-(trimethylsiloxy)-benzophenon | 1,0 | 75 |
| 7 | 1 : | 8 | 11,1 | 88,9 | 500 | " | 2,0 | 73 |
| 8 | 1 : | 1,05 | 47,5 | 62,5 | 680 | Xanthon | 0,1 | 87 |
| 9 | 1 : | 1,7 | 37 | 63 | 630 | " | 0,1 | 72 |

Patentansprüche:

1. Organopolysiloxane, die in ein und demselben Molekül sowohl SiC-gebundene Acryloxyalkylgruppen oder ein Gemisch solcher Gruppen als auch Si-gebundenen Wasserstoff enthalten, dadurch gekennzeichnet, daß sie eine Viskosität von mindestens 100 mPa.s bei 25°C aufweisen.

2. Organopolysiloxane nach Anspruch 1, dadurch gekennzeichnet, daß sie aus Siloxaneinheiten der Formel

$$CH_2{=}CHCOO(CH_2)_nSiR_2O_{1/2} ,$$

wobei R gleiche oder verschiedene, einwertige, gegebenenfalls substituierte Kohlenwasserstoffe und n 1, 2, 3 oder 4 bedeutet,

$$R_2SiO ,$$

wobei R die vorstehend dafür angegebene Bedeutung hat, und

$$CH_3HSiO$$

aufgebaut sind.

3. Organopolysilxoane nach Anspruch 2, dadurch gekennzeichnet, daß n 3 ist.

4. Verfahren zur Herstellung von Organopolysiloxane nach mindestens einem der Ansprüche 1 bis 3, dadurch gekennzeichnet, daß

an in den endständigen Einheiten je ein Si-gebundenes Wasserstoffatom enthaltende Diorganopolysiloxane Allylalkohol angelagert wird,

die alkoholischen Hydroxylgruppen, der so erhaltenen Umsetzungsprodukte mit Acrylsäure verestert werden

und die so erhaltenen, in den endständigen Einheiten je eine SiC-gebundene Acryloxypropylgruppe aufweisenden Diorganopolysiloxane mit in den endständigen Einheiten je eine Si-gebundene Hydroxylgruppe aufweisenden Organo(poly)siloxane aus Methylhydrogensiloxaneinheiten und gegebenenfalls Siloxaneinheiten der Formel

$$R_2SiO ,$$

wobei R die oben dafür angegebene Bedeutung hat, sowie gegebenenfalls anderen Organo(poly)siloxanen äquilibriert werden, wobei der Anteil an monofunktionellen Siloxaneinheiten so zu wählen ist, daß das durch Äquilibrieren erhaltene Organopolysiloxan eine Viskosität von mindestens 100 mPa.s bei 25°C besitzt.

5. Verwendung der Organopolysiloxane nach mindestens einem der Ansprüche 1 bis 3 oder der gemäß Anspruch 4 hergestellten Organopolysiloxane zur Herstellung von durch energiereiche Strahlen vernetzbaren Überzügen.

6. Verwendung der Organopolysiloxane nach Anspruch 5, d a d u r c h g e k e n n z e i c h n e t , daß klebrige Stoffe abweisende Überzüge auf Papier hergestellt werden.

7. Verwendung der Organopolysiloxane nach Anspruch 5, d a d u r c h g e k e n n z e i c h n e t , daß es sich bei den energiereichen Strahlen um Ultraviolett-Licht handelt.